# EUROPÄISCHE PATENTANMELDUNG

(11) **EP 2 287 985 A2**
(43) Veröffentlichungstag der Anmeldung: **23.02.2011**
(21) Anmeldenummer: 10173091.9
(22) Anmeldetag: 17.08.2010
(51) Int. Cl.: H02B 1/28, H05K 5/02

(54) **Brandschutzgehäuse**

(30) Priorität: 21.08.2009 DE 102009038279
(71) Anmelder: Günther Spelsberg GmbH & Co. KG, 58579 Schalksmühle (DE)
(72) Erfinder: Spelsberg, Holger, 58579, Schalksmühle (DE); Quardt, Dirk, 58638, Iserlohn (DE); Scheib, Andreas, 58239, Schwerte (DE); Wirth, Walter, 58579, Schalksmühle (DE)
(74) Vertreter: Michalski Hüttermann & Partner Patentanwälte

(57) **Zusammenfassung**

Die Erfindung betrifft ein Brandschutzgehäuse mit einem Außengehäuse (1) aus einem feuerhemmendem Material und einem Elektroinstallationsgehäuse (2) zur Aufnahme einer elektrischen Einrichtung (3), wobei das Außengehäuse (1) eine verschließbare äußere Öffnung (4) aufweist, das Elektroinstallationsgehäuse (2) eine verschließbare innere Öffnung (7) aufweist, das Elektroinstallationsgehäuse (2) bei geschlossener innerer Öffnung (7) die elektrische Einrichtung (3) feuchtigkeitsdicht umschließt, und das Elektroinstallationsgehäuse (2) in dem Außengehäuse (1) vorgesehen ist. Das erfindungsgemäße Brandschutzgehäuse ermöglicht die Realisierung eines besonders kostengünstigen und einfachen Funktionserhalts für ein aus dem Stand der Technik bekanntes Elektroinstallationsgehäuse (2).

## Beschreibung

Die Erfindung betrifft ein Brandschutzgehäuse mit einem Außengehäuse aus einem feuerhemmenden Material und einem Elektroinstallationsgehäuse zur Aufnahme einer elektrischen Einrichtung.

Damit bei einem Brand wichtige technische Einrichtungen, wie Beleuchtungen, Brandmeldesysteme oder Rauchabzuganlagen, funktionstüchtig bleiben und Rettungswege nutzbar sind, ist es zwingend erforderlich, die elektrische Energieversorgung für diese Systeme besonders abzusichern. Diverse Vorschriften verlangen beispielsweise, dass die Energieversorgung auch im Falle eines Brandes für einen bestimmten Zeitraum sichergestellt sein muss. In diesem Zusammenhang beschreibt der Feuerwiderstand, auch Brandwiderstand genannt, eines Bauteils das Brandverhalten eines Stoffes des Bauteils. Dabei wird der Feuerwiderstand an der Dauer, für die ein Bauteil im Brandfall seine Funktion behält, bemessen. Übliche Feuerwiderstandsklassen, auch als Brandschutzklassen bezeichnet, sind nach DIN 4102 beispielsweise E30, E60 oder E90, wobei der Kennbuchstabe "E" für Elektroinstallationen, insbesondere Elektroinstallationskanal oder Installationsleitungen, steht und die Ziffer 30, 60 oder 90 angibt, dass das Bauteil im Brandfall mindestens 30, 60 oder 90 Minuten seine Funktion erfüllt.

Aus dem Stand der Technik sind verschiedenste Brandschutzgehäuse, wie eingangs genannt, bekannt, die den vorab genannten Feuerwiderstandsklassen genügen und welche beispielsweise zum Anschluss elektrischer Kabel dienen. Dazu werden die elektrischen Kabel im Allgemeinen durch in Seitenwänden des Brandschutzgehäuses vorgesehenen Öffnungen hindurchgeführt. Um nun die in Rede stehende Brandschutzwirkung erfüllen zu können, ist bei den aus dem Stand der Technik bekannten Brandschutzgehäusen typischerweise ein Außengehäuse aus einem feuerhemmenden Material vorgesehen, welches innen beispielsweise mit Platten aus einem Brandschutzmittel verkleidet ist. Das Brandschutzmittel weist jedenfalls eine stark wärmeisolierende Wirkung, vorzugsweise jedoch auch eine zumindest in gewissem Masse aufschäumende Wirkung im Brandfall auf, so dass der Innenraum der aus dem Stand der Technik bekannten Brandschutzgehäuse im Brandfall wenigstens für eine gewisse Zeitdauer vor zu großer Hitzeentwicklung geschützt ist. Ist darüber hinaus vorgesehen, dass die Öffnungen, durch die die Kabel in den Innenraum des Brandschutzgehäuses hineingeführt sind, mit einem Brandschutzschaum abgedichtet sind, also einem Mittel, das im Brandfall stark aufschäumt und damit abdichtend wirkt, kann ein Funktionserhalt, wie eingangs genannt, der in dem Brandschutzgehäuse vorgesehenen elektrischen Einrichtungen für eine vorbestimmte Zeit von wenigstens 30, 60 oder 90 Minuten erzielt werden.

Gegenüber den aus dem Stand der Technik bekannten Elektroinstallationsgehäusen zur Aufnahme einer elektrischen Einrichtung, wie einer elektrischen Schalt- und/oder Verbindungseinrichtung, sind derartige elektrische Einrichtungen in den aus dem Stand der Technik bekannten Brandschutzgehäusen nur sehr aufwändig und umständlich zu installieren und/oder, beispielsweise bei einer Reparatur, auszutauschen. Ebenfalls bieten die aus dem Stand der Technik bekannten Elektroinstallationsgehäuse, verglichen mit den aus dem Stand der Technik bekannten Brandschutzgehäusen, weitaus mehr und komfortablere Möglichkeiten elektrische Einrichtungen zu installieren bzw. auszutauschen.

Daher ist es die Aufgabe der Erfindung, ein Brandschutzgehäuse anzugeben, in dem in besonders einfacher Weise eine elektrische Einrichtung installiert und/oder ausgetauscht werden kann.

Die Lösung der Aufgabe erfolgt erfindungsgemäß durch die Merkmale des unabhängigen Anspruchs. Vorteilhafte Ausgestaltungen der Erfindung sind in den Unteransprüchen angegeben.

Demnach erfolgt die Lösung der Aufgabe durch ein Brandschutzgehäuse mit einem Außengehäuse aus einem feuerhemmenden Material und einem Elektroinstallationsgehäuse zur Aufnahme einer elektrischen Einrichtung, wobei das Außengehäuse eine verschließbare äußere Öffnung aufweist, das Elektroinstallationsgehäuse eine verschließbare innere Öffnung aufweist, das Elektroinstallationsgehäuse bei geschlossener innerer Öffnung die elektrische Einrichtung feuchtigkeitsdicht umschließt, und das Elektroinstallationsgehäuse in dem Außengehäuse vorgesehen ist.

Erfindungsgemäß wird damit ein Brandschutzgehäuse angegeben, das ein Außengehäuse aus einem feuerhemmenden, vorzugsweise aus einem hochfeuerhemmenden oder aus einem feuerbeständigen, Material aufweist und in dem ein Elektroinstallationsgehäuse, beispielsweise ein aus dem Stand der Technik bekanntes Elektroinstallationsgehäuse, zur Aufnahme einer elektrischen Einrichtung vorgesehen ist, wobei das Elektroinstallationsgehäuse die elektrische Einrichtung feuchtigkeitsdicht umschließt. Dadurch, dass in dem Brandschutzgehäuse ein aus dem Stand der Technik bekanntes und feuchtigkeitsdichtes Elektroinstallationsgehäuse vorgesehen ist, kann eine Vielzahl unterschiedlichster elektrischer Einrichtungen, wie beispielsweise elektrische Schalt- und/oder Verbindungseinrichtungen, wie Schütze, Relais, Sicherungen und/oder Klemmen, in herkömmlicher und aus dem Stand der Technik bekannter einfacher Weise durch die feuchtigkeitsverschließbare innere Öffnung hindurch in dem Elektroinstallationsgehäuse montiert bzw. ausgetauscht werden, so dass die elektrischen Einrichtungen in dem Elektroinstallationsgehäuse feuchtigkeitsdicht "isoliert" sind. Die feuchtigkeitsverschließbare innere Öffnung erlaubt also eine sehr einfache Installation derartiger elektrischer Einrichtungen in dem Elektroinstallationsgehäuse.

Ebenfalls erlaubt die Erfindung, ein aus dem Stand der Technik bekanntes Elektroinstallationsgehäuse zur Aufnahme einer elektrischen Einrichtung mit einem Außengehäuse aus einem feuerhemmenden Material zu versehen, so dass das Elektroinstallationsgehäuse in dem Außengehäuse vorgesehen ist und das Elektroinstallationsgehäuse durch eine verschließbare äußere Öffnung des Außengehäuses erreichbar ist. Mit anderen Worten ist also vorgesehen, dass das Außengehäuse das Elektroinstallationsgehäuse vorzugsweise vollständig umschließt. Es ist also bevorzugt, dass das Außengehäuse ein äußeres Volumen einschließt, wobei das Elektroinstallationsgehäuse in dem äußeren Volumen vorgesehen ist. Das erfindungsgemäße Brandschutzgehäuse gewährleistet also im Brandfall, dass das von dem Außengehäuse umschlossene Elektroinstallationsgehäuse seine Funktion behält, also die in dem Elektroinstallationsgehäuse vorsehbare elektrische Einrichtung ihre Funktion behält, dadurch, dass das Außengehäuse aus einem feuerhemmenden Material ausgeführt ist.

Grundsätzlich kann das feuerhemmende Material als ein beliebiges aus dem Stand der Technik bekanntes feuerhemmendes, hochfeuerhemmendes oder feuerbeständigen Material ausgeführt sein. Gemäß einer weiteren bevorzugten Ausführungsform der Erfindung ist jedoch bevorzugt, dass das feuerhemmende Material eine wasserhaltige Schicht aufweist und die wasserhaltige Schicht an wenigstens einer Seite von einer faserhaltigen Schicht umschlossen ist.

Vorzugsweise ist die wasserhaltige Schicht wenigstens an der äußeren Seite des Außengehäuses von der faserhaltigen Schicht umschlossen. Eine derartige Ausgestaltung ist vorteilhaft, da im Brandfall Hitze in das Außengehäuse eindringt und die Temperatur der wasserhaltigen Schicht auf etwa 100°C ansteigen lässt, so dass das in der wasserhaltigen Schicht befindliche Wasser verdampft und in die vorzugsweise äußere faserhaltige Schicht eindringt. Da Wasserdampf bei Atmosphärendruck eine annähernd konstante Temperatur von 100°C aufweist, wird sowohl die wasserhaltige Schicht als auch die vorzugsweise äußere Faserschicht auf nicht mehr als 100°C aufgeheizt, so dass gegenüber den Temperaturen des Brandherdes von etwa 1000°C das auf etwa 100°C aufgeheizte Brandschutzgehäuse derart "gekühlt" ist, dass das im Inneren des Brandschutzgehäuses befindliche feuchtigkeitsdicht abgeschlossene Elektroinstallationsgehäuse bzw. eine darin vorsehbare elektrische Einrichtung über eine Zeitdauer seine bzw. ihre Funktion erhält. Der Zeitdauer lässt sich über den Wassergehalt der wasserhaltigen Schicht bestimmen, also beispielsweise durch eine Erhöhung des Wassergehalts die Zeitdauer vergrößern.

Demnach erlaubt das erfindungsgemäße Brandschutzgehäuse also zum einen elektrische Einrichtungen in dem Elektroinstallationsgehäuse besondern einfach vorzusehen, bspw. aufgrund der "bequemen" Erreichbarkeit des Inneren des Elektroinstallationsgehäuses durch die äußere Öffnung und durch die innere Öffnung sowie aufgrund der einfachen Installierbarkeit der elektrischen Einrichtungen aufgrund der "Handelsüblichkeit" des Elektroinstallationsgehäuses, so dass die "Handhabung" des erfindungsgemäßen Brandschutzgehäuses gegenüber den aus dem Stand bekannten Brandschutzgehäusen wesentlich vereinfacht ist. Zum anderen erlaubt das erfindungsgemäße Brandschutzgehäuse die elektrischen Einrichtungen aufgrund der Feuchtigkeitsdichtigkeit des Elektroinstallationsgehäuses besonders gut gegen Feuchtigkeit zu "isolieren", bspw. aufgrund der im Brandfall aus dem feuerhemmenden Material bzw. der wasserhaltigen Schicht austretenden Feuchtigkeit.

Weiterhin ist bevorzugt, dass die faserhaltige Schicht Steinwollfaser mit einem Metalloxidanteil, wie beispielsweise Aluminiumoxid, umfasst. Die faserhaltige Schicht kann fern eine biolösliche Steinwollfaser mit einem Oxidanteil auf, insbesondere Na₂O, K₂O, CaO, MgO, BaO, Al₂O₃, SiO₂ oder ZrO₂. Ganz besonders ist bevorzugt, dass die wasserhaltige Schicht an ihren beiden Seiten von einer jeweiligen faserhaltigen Schicht umschlossen ist, wobei vorzugsweise die dem Elektroinstallationsgehäuse zugewandte faserhaltige Schicht eine höhere Dichte als die dem Elektroinstallationsgehäuse nicht zugewandte faserhaltige Schicht aufweist. Dadurch kann erreicht werden, dass der Wasserdampf aus der wasserhaltigen Schicht in die dem Elektroinstallationsgehäuse nicht zugewandte faserhaltige Schicht eindringt und dort die Temperatur auf 100°C absenkt. Weiterhin ist bevorzugt, dass die wasserhaltige Schicht und/oder die faserhaltige Schicht als Platte und/oder Matte ausgestaltet ist.

Gemäß einer anderen bevorzugten Ausführungsform der Erfindung ist vorgesehen, dass das feuerhemmende Material Gips aufweist. In diesem Zusammenhang ist weiterhin bevorzugt, dass das feuerhemmende Material eine Gipsplatte ist. Derartige Ausgestaltungen sind insofern vorteilhaft, da Gips kostengünstig, einfach herstellbar, leicht zu bearbeiten und einfach in eine gewünschte Form zu bringen ist.

Grundsätzlich kann die verschließbare äußere Öffnung beliebig ausgestaltet sein. Gemäß einer weiteren bevorzugten Ausführungsform der Erfindung ist jedoch vorgesehen, dass die verschließbare äußere Öffnung eine äußere Tür umfasst. Die äußere Tür kann beispielsweise herausnehmbar oder drehbar gelagert sein, wobei die äußere Tür beispielsweise durch ein Schloss verschließbar ausgestaltet sein kann.

Wie zuvor schon angedeutet, kann das Elektroinstallationsgehäuse als ein aus dem Stand der Technik bekanntes Elektroinstallationsgehäuse ausgestaltet sein. Ganz besonders ist gemäß einer weiteren Ausführungsform der Erfindung jedoch bevorzugt, dass das Elektroinstallationsgehäuse wenigstens teilweise aus Kunststoff ausgeführt ist. Derartig ausgeführt, ermöglicht das Elektroinstallationsgehäuse einen Funktionserhalt im Brandfall durch Anordnung in dem Außengehäuse.

Gemäß einer anderen bevorzugten Ausführungsform der Erfindung ist jedoch vorgesehen, dass die verschließbare innere Öffnung der verschließbaren äußeren Öffnung zugewandt ist. Demnach ist also bevorzugt, dass beispielsweise eine innere Tür zum Verschließen der inneren Öffnung vorgesehen ist, wobei die innere Tür der äußeren Tür zugewandt ist. Zum Installieren oder Auswechseln einer elektrischen Einrichtung ist also in einem ersten Schritt die äußere Tür des Außengehäuses zu öffnen und in einem zweiten Schritt die innere Tür des Elektroinstallationsgehäuses zu öffnen.

Weiterhin ist bevorzugt, dass das Elektroinstallationsgehäuse ein abgeschlossenes Gehäuse aufweist, also beispielsweise ein inneres Volumen einschließt. Weiterhin kann ein Brandschutzmittel zwischen dem Außengehäuse und dem Elektroinstallationsgehäuse vorgesehen sein, welches vorzugsweise das derart gebildete Volumen zwischen dem Außengehäuse und dem Elektroinstallationsgehäuse teilweise oder vollständig ausfüllt.

Grundsätzlich kann das Elektroinstallationsgehäuse zur Aufnahme einer beliebigen elektrischen und/oder mechanischen Einrichtung vorgesehen sein. Gemäß einer weiteren Ausführungsform der Erfindung ist jedoch bevorzugt, dass das Elektroinstallationsgehäuse eine elektrische Einrichtung aufweist. Hierbei kann die elektrische Einrichtung als eine beliebige aus dem Stand der Technik bekannte elektrische Einrichtung ausgeführt sein, welche beispielsweise auf einem Bosch-Profil in dem Elektroinstallationsgehäuse montierbar ist. In diesem Zusammenhang ist weiterhin bevorzugt, dass die elektrische Einrichtung in dem Elektroinstallationsgehäuse angeordnet ist.

Im Einzelnen gibt es nun eine Vielzahl von Möglichkeiten, ein Kabel und/oder eine Leitung in das Brandschutzgehäuse einzuführen. In diesem Zusammenhang ist gemäß einer weiteren Ausführungsform der Erfindung bevorzugt, dass das Außengehäuse und/oder das Elektroinstallationsgehäuse eine Kabeleinführung aufweisen. Weiterhin ist bevorzugt, dass die Kabeleinführung mit einem Material abgedichtet ist, das im Brandfalle expandiert, nämlich vorzugsweise aufschäumt und somit eine Isolierung des Brandschutzgehäuses im Brandfall ermöglicht.

Nach einer anderen bevorzugten Ausführungsform der Erfindung ist vorgesehen, dass das Elektroinstallationsgehäuse mit geschlossener innerer Öffnung die elektrische Einrichtung feuchtigkeitsdicht gemäß Schutzklasse IP 65, vorzugsweise gemäß Schutzklasse IP 67 und ganz bevorzugt gemäß Schutzklasse IP 68 umschließt. Vorzugsweise entsprechen die vorgenannten Schutzklassen dabei der Norm DIN EN 60529, so dass jeweils eine sehr gute Feuchtigkeitsdichtigkeit des Elektroinstallationsgehäuses bzw. der geschlossenen inneren Öffnung des Elektroinstallationsgehäuses erreicht wird.

Gemäß einer weiteren bevorzugten Ausführungsform der Erfindung ist vorgesehen, dass das Brandschutzgehäuse einen Funktionserhalt der elektrischen Einrichtung von 30 Minuten, 60 Minuten oder 90 Minuten gemäß DIN 4102 gewährleistet. Weiterhin ist bevorzugt, dass das feuerhemmende Material derart gewählt ist, dass ein Funktionserhalt der elektrischen Einrichtung von 30 Minuten, 60 Minuten oder 90 Minuten gemäß DIN 4102 gewährleistet ist. Es ist also bevorzugt, dass das erfindungsgemäße Elektroinstallationsgehäuse bzw. das feuerhemmende Material den in der DIN 4102 definierten Tauglichkeitsbeweisen zum Funktionserhalt im Brandfall genügt, also den Anforderungen der in der DIN 4102 definierten Feuerwiderstandsklassen, die eine Funktionserfüllung im Brandfall von 30 Minuten, 60 Minuten oder 90 Minuten, für die elektrische Einrichtung genügt. Demnach ist also bevorzugt, dass das Brandschutzgehäuse bzw. das feuerhemmende Material nicht nur feuerhemmend, sondern auch hochfeuerhemmend oder feuerbeständig ausgeführt sind, also gemäß der Erfindung ein Brandschutzgehäuse bereitgestellt wird, das in besonders einfacher und günstiger Bauweise einen Funktionserhalt im Brandfall für die elektrische Einrichtung ermöglicht. In analoger Weise ist bevorzugt, dass das Brandschutzgehäuse bzw. das feuerhemmende Material einen Funktionserhalt gemäß der englischen Norm BS 476 oder der kanadischen Norm MBO-NBC ermöglicht.

Nachfolgend wird die Erfindung unter Bezugnahme auf die Zeichnung weiter im Detail erläutert. In der Zeichnung zeigt:

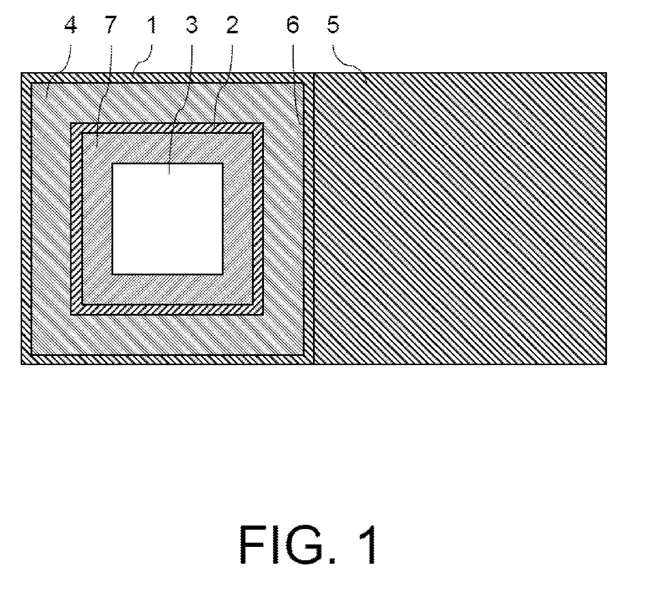

- Fig. 1: ein Brandschutzgehäuse mit einem Außengehäuse und einem Elektroinstallationsgehäuse gemäß einem bevorzugten Ausführungsbeispiel der Erfindung in einer Draufsicht.

Aus Fig. 1 ist ein Brandschutzgehäuse mit einem Außengehäuse 1 aus einem feuerhemmenden Material und einem Elektroinstallationsgehäuse 2 zur Aufnahme einer elektrischen Einrichtung 3 ersichtlich. Das Außengehäuse 1 weist eine verschließbare äußere Öffnung 4 auf, welche vorliegend als äußere Tür 5 ausgeführt ist, wobei die äußere Tür 5 drehbar an der rechten Seitenwand 6 des Außengehäuses 1 gelagert ist. Somit ist also die äußere Öffnung 4, also auch das Außengehäuse 1, mittels der äußeren Tür 5 verschließbar.

Das feuerhemmende Material des Außengehäuses 1 weist eine wasserhaltige Schicht auf, die an beiden Seiten von einer faserhaltigen Schicht umschlossen ist. Eine derartige Ausgestaltung ist vorteilhaft, da im Brandfall Hitze in das Außengehäuse 1 eindringt und die Temperatur der wasserhaltigen Schicht auf etwa 100°C ansteigen lässt, so dass das in der wasserhaltigen Schicht befindliche Wasser verdampft und in die äußere faserhaltige Schicht eindringt.

Da Wasserdampf bei Atmosphärendruck eine konstante Temperatur von annähernd 100°C aufweist, wird sowohl die wasserhaltige Schicht als auch die äußere Faserschicht auf nicht mehr als 100°C aufgeheizt, so dass gegenüber den Temperaturen des Brandherdes von etwa 1000°C das auf etwa 100°C aufgeheizte Brandschutzgehäuse derart "gekühlt" ist, dass das im Inneren des Brandschutzgehäuses befindliche Elektroinstallationsgehäuse 2 bzw. die darin befindliche elektrische Einrichtung 3 über eine Zeitdauer seine bzw. ihre Funktion erhält.

Die Zeitdauer lässt sich über den Wassergehalt der wasserhaltigen Schicht bestimmen, also durch eine Erhöhung des Wassergehalts der wasserhaltigen Schicht lässt sich die Zeitdauer vergrößern, wobei vorliegend die Zeitdauer 30 Minuten, 60 Minuten oder 90 Minuten beträgt.

Die faserhaltige Schicht kann ein Steinwollfaser mit einem Metalloxidanteil aufweisen, wie beispielsweise Aluminiumoxid, oder eine biolösliche Steinwollfaser mit einem Oxidanteil aufweisen, insbesondere Na₂O, K₂O, CaO, MgO, BaO, Al₂O₃, SiO₂ oder ZrO₂. Dabei ist vorgesehen, dass die dem Elektroinstallationsgehäuse 2 zugewandte faserhaltige Schicht eine höhere Dichte als die dem Elektroinstallationsgehäuse 2 nicht zugewandte faserhaltige Schicht aufweist. Dadurch kann erreicht werden, dass der Wasserdampf aus der wasserhaltigen Schicht in die dem Elektroinstallationsgehäuse 2 nicht zugewandte faserhaltige Schicht eindringt und dort die Temperatur auf 100°C absenkt. Vorliegend ist das Außengehäuse 1 aus Gips bzw. Gipsplatten ausgeführt.

Das Elektroinstallationsgehäuse 2 ist ein aus dem Stand der Technik bekanntes Elektroinstallationsgehäuse 2 zur Aufnahme einer beliebigen elektrischen und/oder mechanischen Einrichtung 3, wie beispielsweise einer Schalt- und/oder Verbindungseinrichtung.

Das Elektroinstallationsgehäuse 2 ist, wie aus Fig. 1 ersichtlich, in dem Außengehäuse 1 vorgesehen, also vollständig von dem Außengehäuse 1 umschlossen. Ebenso wie das Außengehäuse 1 weist das Elektroinstallationsgehäuse 2 eine innere Öffnung 7 auf, welche durch eine innere Tür, nicht dargestellt, feuchtigkeitsdicht verschließbar ist. Erfindungsgemäß ist bei verschlossener innerer Öffnung 7 das Elektroinstallationsgehäuse 2 feuchtigkeitsdicht abgeschlossen, also die in dem Elektroinstallationsgehäuse 2 befindliche elektrische Einrichtung 3 feuchtigkeitsdicht umschlossen. Dabei ist weiterhin vorgesehen, dass die Feuchtigkeitsdichtigkeit wenigstens der Schutzklasse IP 65 entspricht.

Derart ausgestaltet erlaubt das ein Außengehäuse 1 aus feuerhemmendem Material aufweisende Brandschutzgehäuse ein beliebiges aus dem Stand der Technik bekanntes Elektroinstallationsgehäuse 2 in dem Außengehäuse 1 vorzusehen, so dass das Brandschutzgehäuse leinen Funktionserhalt der elektrischen Einrichtung 3 über 30 Minuten, 60 Minuten oder 90 Minuten gemäß DIN 4102 gewährleistet.

Überraschenderweise wurde also gefunden, dass ein Elektroinstallationsgehäuse 2 zur Aufnahme einer elektrischen Einrichtung 3 in einem Außengehäuse 1 aus einem feuerhemmenden Material vorsehbar ist, und derartig ausgestaltet einen Funktionserhalt der elektrischen Einrichtung 3 über 30 Minuten, 60 Minuten oder 90 Minuten gemäß DIN 4102 gewährleistet. Mit anderen Worten erlaubt das erfindungsgemäße Brandschutzgehäuse die Realisierung eines besonders kostengünstigen und einfachen Funktionserhalts für ein aus dem Stand der Technik bekanntes Elektroinstallationsgehäuse 2.

## Patentansprüche

1. Brandschutzgehäuse mit einem Außengehäuse (1) aus einem feuerhemmenden Material und einem Elektroinstallationsgehäuse (2) zur Aufnahme einer elektrischen Einrichtung (3), wobei
das Außengehäuse (1) eine verschließbare äußere Öffnung (4) aufweist,
das Elektroinstallationsgehäuse (2) eine verschließbare innere Öffnung (7) aufweist, das Elektroinstallationsgehäuse (2) bei geschlossener innerer Öffnung (7) die elektrische Einrichtung (3) feuchtigkeitsdicht umschließt, und
das Elektroinstallationsgehäuse (2) in dem Außengehäuse (1) vorgesehen ist.

2. Brandschutzgehäuse nach Anspruch 1, wobei das feuerhemmende Material eine wasserhaltige Schicht aufweist und die wasserhaltige Schicht an wenigstens einer Seite von einer faserhaltigen Schicht umschlossen ist.

3. Brandschutzgehäuse nach einem der vorhergehenden Ansprüche, wobei das feuerhemmende Material Gips aufweist.

4. Brandschutzgehäuse nach einem der vorhergehenden Ansprüche, wobei die verschließbare äußere Öffnung (4) eine äußere Tür (5) umfasst.

5. Brandschutzgehäuse nach einem der vorhergehenden Ansprüche, wobei das Elektroinstallationsgehäuse (2) wenigstens teilweise aus Kunststoff ausgeführt ist.

6. Brandschutzgehäuse nach einem der vorhergehenden Ansprüche, wobei die verschließbare innere Öffnung (7) der verschließbaren äußeren Öffnung (4) zugewandt ist.

7. Brandschutzgehäuse nach Anspruch 6, wobei die verschließbare innere Öffnung (7) eine innere Tür umfasst.

8. Brandschutzgehäuse nach einem der vorhergehenden Ansprüche, wobei das Elektroinstallationsgehäuse (2) eine elektrische Einrichtung (3) aufweist.

9. Brandschutzgehäuse nach Anspruch 8, wobei die elektrische Einrichtung (3) in dem Elektroinstallationsgehäuse (2) angeordnet ist.

10. Brandschutzgehäuse nach einem der vorhergehenden Ansprüche, wobei das Außengehäuse (1) und/oder das Elektroinstallationsgehäuse (2) eine Kabeleinführung aufweisen.

11. Brandschutzgehäuse nach einem der vorhergehenden Ansprüche, wobei das Elektroinstallationsgehäuse (2) mit geschlossener innerer Öffnung (7) die elektrische Einrichtung (3) feuchtigkeitsdicht gemäß Schutzklasse IP 65, vorzugsweise gemäß Schutzklasse IP 67 und ganz bevorzugt gemäß Schutzklasse IP 68 umschließt.

12. Brandschutzgehäuse nach einem der vorhergehenden Ansprüche, wobei das Brandschutzgehäuse einen Funktionserhalt der elektrischen Einrichtung (3) von 30 Minuten, 60 Minuten oder 90 Minuten gemäß DIN 4102 gewährleistet.

13. Brandschutzgehäuse nach einem der vorhergehenden Ansprüche, wobei das feuerhemmende Material derart gewählt ist, dass ein Funktionserhalt der elektrischen Einrichtung (3) von 30 Minuten, 60 Minuten oder 90 Minuten gemäß DIN 4102 gewährleistet ist.
